(19) Europäisches Patentamt
European Patent Office
Office européen des brevets

(11) **EP 2 372 917 B1**

(12) **FASCICULE DE BREVET EUROPEEN**

(45) Date de publication et mention
de la délivrance du brevet:
**21.03.2012   Bulletin 2012/12**

(51) Int Cl.:
***H03M 1/14*** *(2006.01)*   *H03M 1/56* *(2006.01)*
***H03M 1/76*** *(2006.01)*

(21) Numéro de dépôt: **11305327.6**

(22) Date de dépôt: **24.03.2011**

(54) **Dispositif de conversion analogique-numérique parallele et detecteur d'imagerie comportant un tel dispositif**

Gerät zur parallelen Analog-Digital-Wandlung und ein solches Gerät umfassender Bildgebungsdetektor

Device for parallel analogue-to-digital conversion and imaging detector comprising such a device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.03.2010   FR 1052433**

(43) Date de publication de la demande:
**05.10.2011   Bulletin 2011/40**

(73) Titulaire: **ULIS**
**38113 Veurey Voroize (FR)**

(72) Inventeur: **Gravot, Vincent**
**38210 Vourey (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
- **MARTIJN F SNOEIJ ET AL: "Multiple-Ramp Column-Parallel ADC Architectures for CMOS Image Sensors", IEEE JOURNAL OF SOLID-STATE CIRCUITS, IEEE SERVICE CENTER, PISCATAWAY, NJ, US, vol. 42, no. 12, 1 décembre 2007 (2007-12-01), pages 2968-2977, XP011197063, ISSN: 0018-9200, DOI: DOI: 10.1109/JSSC.2007.908720**
- **SEUNGHYUN LIM ET AL: "A High-Speed CMOS Image Sensor With Column-Parallel Two-Step Single-Slope ADCs", IEEE TRANSACTIONS ON ELECTRON DEVICES, IEEE SERVICE CENTER, PISACATAWAY, NJ, US, vol. 56, no. 3, 1 mars 2009 (2009-03-01), pages 393-398, XP011252327, ISSN: 0018-9383**

**Description**

**DOMAINE DE L'INVENTION**

La présente invention concerne la conversion analogique/numérique d'un grand nombre de signaux analogiques disponibles simultanément, et notamment la conversion analogique/numérique de signaux en provenant de détecteurs matriciels.

**ETAT DE LA TECHNIQUE**

Un détecteur matriciel comporte classiquement une matrice de photodétecteurs, une électronique de lecture qui forme des signaux analogiques, usuellement des tensions, en relation avec les photodétecteurs, ainsi qu'une électronique de conversion analogique/numérique convertissant les signaux analogiques délivrés par le circuit de lecture en des valeurs numériques.

Pour des raisons de simplicité d'interface, la matrice d'éléments photosensibles et l'électronique de lecture et de conversion sont généralement réalisées en un seul composant.

Un besoin constant concerne la conception d'une électronique de conversion qui soit rapide, faible consommatrice d'énergie et de faible emprise surfacique.

Pour réduire l'emprise surfacique de l'électronique de conversion, une technique consiste à ne prévoir qu'un unique circuit de conversion analogique/numérique (ou circuit « CAN ») chargé de la conversion de l'ensemble des signaux analogiques issus de la matrice de photodétecteurs.

En ne prévoyant qu'un seul circuit CAN, le nombre de composants électroniques est ainsi réduit, et donc corollairement leur emprise surfacique. Le circuit CAN doit cependant convertir tous les signaux issus de la matrice pendant la durée d'une trame et se doit donc d'être très rapide. Or, plus un circuit CAN est rapide, plus il est consommateur d'énergie. En outre, la consommation d'un circuit CAN est sur-linéaire à mesure que sa fréquence de fonctionnement s'approche de ses limites physiques. De plus, en raison même de ces limites physiques de fonctionnement, il n'existe pas aujourd'hui de circuit CAN série unique capable de numériser un détecteur matriciel au format VGA au-delà de 30 Hertz.

Afin d'augmenter la rapidité de la conversion analogique/numérique, et ainsi réduire la consommation d'énergie en éloignant la fréquence de fonctionnement des circuits de leur limite de fonctionnement et/ou permettre d'augmenter la fréquence de trame, il est connu de prévoir plusieurs circuits CAN pour le détecteur. Par exemple, il est connu de prévoir deux circuits CAN associés aux lignes paires et impaires, ou un circuit associé à chaque cadrant de la matrice de photodétecteurs, ou encore un circuit CAN associé à chaque colonne de la matrice de photodétecteurs, voire même un circuit CAN par photodétecteur de la matrice.

Toutefois, bien que le problème de consommation d'énergie liée à la sur-linéarité soit évité, un circuit CAN consomme une quantité non négligeable d'énergie en régime linéaire.

En effet, le principe habituel générique des convertisseurs selon les techniques connues, consiste en la modification analogique en une ou plusieurs phases du signal à numériser lui-même.

Un CAN dit « pipeline » par exemple, habituellement mis en oeuvre sur la ou chaque sortie série d'un détecteur matriciel, fonctionne à l'aide d'étages successifs de numérisation sur un nombre limité de bits, séparés par la formation de résidus intermédiaires destinés à la numérisation par l'étage suivant. Quatre étages de 3 bits chacun de poids décroissants représente un exemple typique d'un CAN pipeline 12 bits. La formation des résidus nécessite typiquement la reconversion numérique-analogique des bits acquis, puis une soustraction du résultat au signal en entrée d'étage, le résidu étant ensuite proposé à l'étage suivant.

La nécessaire extrême précision de ces opérations de soustractions répétées nécessite la mise en oeuvre d'amplificateurs à gains très élevés, c'est-à-dire à plusieurs étages et comportant de nombreux transistors. La rapidité nécessaire de tels convertisseurs impose de mener les fonctions analogiques sous des courants élevés, en régime sur-linéaire et donc très consommateur d'énergie. Un CAN pipeline s'avère très efficace, mais limité par la fréquence de fonctionnement nécessaire et la sur-linéarité associée dès que le format à convertir est conséquent.

Un autre type de CAN a été développé pour contourner cette limitation, dit « CAN double rampe ». Le principe est dans ce cas de former une première série de bits de poids fort par la décharge rapide, selon une première rampe de tension, d'une capacité dont la charge représente le signal à numériser, en comptant le nombre d'impulsions d'horloge, puis de former les bits de poids faible sur le résidu de la même manière, mais à l'aide d'une décharge plus lente jusqu'à extinction de la charge initiale. Ces opérations sont menées à l'aide d'un ou de plusieurs circuits analogiques qui modifient temporellement le signal à numériser de manière contrôlée (amplificateur, intégrateur etc.) Ces convertisseurs sont nettement plus rapides, mais là encore, comme pour les convertisseurs pipeline, ces fonctions analogiques représentent l'essentiel de l'énergie consommée.

Par principe, selon ces techniques connues, un signal à numériser est donc modifié lors du processus de conversion par la partie analogique du convertisseur, laquelle est donc mobilisée jusqu'à complétion de sa tâche. Lors de la conversion d'une pluralité de signaux analogiques, chaque signal mobilise la partie analogique du (ou d'un des) convertisseur(s). En d'autres termes, il y a autant de traitements analogiques à effectuer que de signaux à numériser pour former une trame. Il s'ensuit que la multiplication des numériseurs dans les architectures parallèles permet de baisser la fréquence et donc les complications de sur-linéarité, mais ne résout pas vraiment le problème de consommation d'énergie.

En outre, en multipliant les circuits CAN, la surface totale de ceux-ci augmente mais également la complexité de conception. Enfin la multiplication des circuits CAN induit un bruit spatial dans les valeurs numériques du fait même des différences de fonctionnement entre ceux-ci, ce qui nécessite un traitement numérique ultérieur pour rétablir la qualité des images.

Ainsi, comme il est possible de le remarquer, la rapidité, la faiblesse de consommation et la faiblesse de l'emprise surfacique constituent des caractéristiques antagonistes dans les conversions analogiques/numériques de grandes quantités de données de l'état de la technique. Usuellement, le choix de la conversion analogique/numérique utilisée est réalisé en fonction d'un compromis propre à l'application visée.

La publication de Martijn F. SNOEIJ et al « Multiple-ramp column-parallele ADC architectures for CMOS image sensors », IEEE JOURNAL OF SOLID-STATE CIRCUITS, vol. 42; no. 12 1er décembre 2007 décrit un procédé de conversion analogique numérique d'une pluralité de tensions.

La publication de Seunghyun LIM et al « A high-speed CMOS image sensor with column-parallel two-step single-slope ADCs », IEEE TRANSACTIONS ON ELECTRON DEVICES, vol. 56, no. 3, 1er mars 2009, décrit un dispositive de conversion analogique numérique en deux étapes.

## EXPOSE DE L'INVENTION

On comprend donc aisément le besoin de disposer d'une conversion analogique/numérique qui soit capable de traiter parallèlement un grand nombre de signaux analogiques, qui soit à la fois rapide, de consommation énergétique et d'emprise surfacique limitées, et qui présente un bruit spatial de conversion négligeable.

Le but de la présente invention est de proposer un procédé et un dispositif de conversion analogique/numérique satisfaisant ce besoin.

A cet effet, l'invention a pour objet un dispositif de conversion analogique-numérique apte à recevoir des tensions à convertir sur des entrées parallèles dont il est muni, ledit dispositif comprenant :

■ un unique circuit de genèse de tensions apte à générer des tensions de référence constantes puis décroissantes dans le temps, selon des valeurs discrètes ledit circuit de genèse de tension (30) comprenant :

o une source de courant (341) apte à générer un premier courant constant ;
o un premier pont résistif (342), formé de résistances en série et connecté à la source de courant constant, les tensions aux noeuds du premier pont résistif formant les tensions de référence ;
o une source de tension (32, 33, 34) apte à produire une tension décroissante sur un noeud d'injection du premier pont résistif ;
o un interrupteur (323) de commande de la connexion de la source de tension au noeud d'injection du premier pont résistif,

■ et un circuit de numérisation connecté à chaque entrée parallèle du dispositif, ledit circuit étant connecté au circuit de genèse des tensions de référence comprenant :

o des moyens de comparaison de la tension à convertir reçue sur l'une des entrées parallèles du dispositif avec les tensions de référence générées par le circuit de genèse de tensions ;
o des moyens de sélection de la tension de référence dont la valeur, lorsque ladite tension de référence est constante, est immédiatement supérieure à la tension à convertir ;
o des moyens de comptage d'un nombre d'unités de temps nécessaires pour que la tension de référence sélectionnée devienne inférieure à la tension à convertir lors de la phase de décroissance de ladite tension de référence ; et
o des moyens de mémorisation d'une part, d'une référence associée à la tension de référence constante qui est immédiatement inférieure ou égale à la tension à convertir et d'autre part, du nombre d'unités de temps comptées, les bits de poids fort de la valeur numérique de la tension à convertir correspondant à ladite référence, et les bits de poids faible de ladite valeur numérique correspondant au nombre d'unité de temps comptées.

En d'autres termes, les fonctions analogiques, notamment la genèse de tensions de référence, sont mises en oeuvre par un unique circuit analogique. Ce trait avantageux exploite le fait que le convertisseur selon l'invention ne modifie pas le signal à numériser, qui est ainsi conservé intact au cours du processus de numérisation. Il n'y a donc plus nécessité de pratiquer autant de traitements analogiques que de signaux à numériser pour former une trame. En d'autres termes, les fonctions analogiques peuvent être mutualisées.

Comme ces fonctions analogiques sont les principales sources de consommation d'énergie et requièrent des composants d'emprise surfacique élevée, l'utilisation d'un unique circuit analogique pour la conversion d'une pluralité de tensions permet donc des économies d'énergie ainsi qu'une réduction de l'emprise surfacique totale du dispositif

En outre, les circuits de numérisation associés aux tensions à convertir sont de conception simple et leurs fonctions (comparaisons, comptage, sélection, mémorisation notamment) peuvent être mises en oeuvre par des composants numériques simples, tels que des comparateurs, des compteurs et des mémoires par exemple. Ces composants numériques sont peu consommateurs d'énergie, et, de manière avantageuse, ne consomment de l'énergie que lors de commutations, c'est-à-dire pendant des périodes de temps réduites.

On notera d'ailleurs à cet égard qu'il n'est pas nécessaire d'amplifier une tension à convertir, au contraire de certains circuits CAN de l'état de la technique, qui comparent la sortie des composants d'une chaine d'amplification recevant la tension à une unique tension de référence. Les tensions à convertir restent ainsi inchangées pendant tout le cycle de numérisation.

Par ailleurs, les circuits de numérisation mettent en oeuvre un nombre réduit de composants numériques de sorte que chacun de ces circuits présente une emprise surfacique réduite. Il est ainsi possible d'utiliser le dispositif de conversion de l'invention dans un détecteur matriciel pour une conversion parallèle des tensions issues de la matrice de photodétecteurs, sans pour autant devoir prévoir à cet effet une grande surface. Par exemple, un circuit de numérisation peut être réalisé au pied de chaque colonne de la matrice de photodétecteurs. La fréquence de trame peut donc être augmentée et/ou le régime de consommation sur-linéaire évité.

Il est également à noter que la principale source de dispersion des caractéristiques de l'état de la technique a disparu. Dans l'état de la technique, il apparaît en effet un bruit spatial de numérisation lorsque plusieurs circuits CAN indépendants sont utilisés du fait de la dispersion des caractéristiques de fonctionnement de ceux-ci. Or, la principale cause de ces dispersions est de nature analogique, les composants numériques présentant quant à eux une dispersion contenue de leurs caractéristiques. En ne prévoyant qu'un seul circuit analogique, les principales causes du bruit spatial de numérisation sont donc absentes. Ainsi, comme il apparaîtra à la lecture de la description des modes de réalisations de l'invention, il ne subsiste essentiellement que les différences spatiales entre des circuits comparateurs.

Ensuite, outre la rapidité de conversion induite par le traitement parallèle des tensions à convertir, le dispositif selon l'invention met en oeuvre une numérisation par comparaison séquentielle à un ensemble discret de tensions de référence constantes pour déterminer les bits de poids fort suivi d'une comparaison à une tension continue décroissante pour déterminer les bits de poids faible.

Enfin, le pont résistif offre notamment l'avantage de fournir simplement et sans consommation excessive d'énergie un moyen de produire simultanément plusieurs tensions de référence. La formation des références de tension à partir d'un pont résistif est précise car il est aisé d'obtenir une série de résistances très linéaires et essentiellement identiques. La source de tension permet quant à elle, lorsqu'elle est connectée à un noeud du pont résistif, de produire une décroissance identique pour toutes les tensions de référence.

Selon un mode de réalisation de l'invention, le circuit de genèse des tensions de référence est configuré pour délivrer des tensions de référence, dont les valeurs sont régulièrement espacées selon un pas prédéterminé, constantes dans le temps ou décroissantes selon une même rampe de tension prédéterminée. Selon un mode de réalisation avantageux de l'invention, le circuit de genèse est configuré pour délivrer $2^H$ tensions de référence régulièrement espacées d'un pas prédéterminé et faire décroitre celles-ci du pas prédéterminé pendant une période de temps égale à $2^L.T_C$, où H est le nombre de bits de poids fort, L est le nombre de bits de poids faible et $T_C$ est la valeur de l'unité de temps.

Ainsi la numérisation est réalisée selon deux rampes, la première discrète et définie par la sélection séquentielle des tensions de référence constantes, et la seconde continue et définie par la rampe de tension prédéterminée. La première rampe présente avantageusement une pente beaucoup plus raide que la pente de la seconde rampe, de sorte qu'il est obtenu une conversion analogique/numérique rapide.

Avantageusement, la seconde source de tension décroissante comporte :

■ un circuit de tension configuré pour produire une tension sensiblement identique à celle du noeud d'injection du premier pont en l'absence de connexion de la source de tension décroissante sur le noeud de référence du premier pont résistif ;
■ un circuit générateur de courant ;
■ un amplificateur opérationnel, contre-réactionné sur son entrée inverseuse par un condensateur, dont l'entrée inverseuse est connectée au circuit générateur de courant, dont l'entrée non-inverseuse est connectée au circuit de tension, et dont la sortie est connectée au noeud d'injection du premier pont résistif.

L'interrupteur pilotable est en outre contre-réactionné sur l'entrée inverseuse de l'amplificateur opérationnel.

Ainsi, lorsque l'interrupteur est fermé, l'amplificateur opérationnel fonctionne en suiveur de sorte qu'il ne fait pas varier la tension sur le noeud d'injection. Les tensions de référence restent donc ainsi constantes. En revanche, lorsque l'interrupteur est ouvert, le courant produit par le générateur de courant est intégré par l'amplificateur contre-réactionné, faisant ainsi décroître la tension de sortie de l'amplificateur et donc la tension au noeud d'injection selon la valeur du courant intégré et de la capacité du condensateur.

Notamment, le générateur de courant comporte :

■ un circuit de détection apte à mesurer la différence entre la tension d'un noeud du premier pont résistif et une valeur attendue pour cette tension à mi-pente, et à produire un courant proportionnel à ladite différence ;
■ un condensateur connecté au circuit de détection et apte à intégrer le courant délivré par celui-ci ; et
■ une source de courant formant le courant délivré par le générateur de courant en fonction de la tension aux bornes du condensateur.

De cette manière, le courant produit par le générateur ajuste automatiquement la pente de la rampe sur la valeur souhaitée pour celle-ci. Une grande précision est ainsi obtenue, et constamment conservée, et cela même en présence d'importantes variations des caractéristiques des composants analogiques, comme par exemple des variations provoquées par un changement de température.

Selon un mode de réalisation de l'invention, le circuit de numérisation comporte en outre un circuit de sélection séquentiel connecté au circuit de genèse des tensions de référence de manière à recevoir de celui-ci les tensions de référence sur des entrées parallèles, ledit circuit de sélection étant apte à sélectionner séquentiellement les tensions de référence selon leurs valeurs décroissantes et à délivrer les tensions sélectionnées aux moyens de comparaison. Notamment, les moyens de comparaison comprennent un comparateur connecté à l'entrée parallèle du dispositif et à la sortie du circuit de sélection séquentielle, et dans lequel les moyens de mémorisation comprennent une mémoire pilotée par la sortie du comparateur et mémorisant l'adresse de l'entrée parallèle du circuit de sélection séquentiel en cours de sélection lors du basculement de la sortie du comparateur.

Ainsi les bits de poids fort sont déterminés directement par l'adresse de l'entrée sélectionnée du circuit de sélection, sans traitement supplémentaire.

Selon une première variante :

■ le circuit de genèse des tensions de référence est apte à générer une tension supplémentaire supérieure aux tensions de référence, et comporte un commutateur pilotable apte à sélectionner et délivrer au circuit de sélection séquentielle, les tensions les plus basses de l'ensemble formé des tensions de référence et de la tension supplémentaire ou les tensions les plus hautes dudit ensemble ;
■ des moyens de commande aptes à faire basculer le commutateur dans son mode de sélection des tensions les plus hautes lors du basculement du comparateur ; et
■ des moyens de blocage du circuit de sélection séquentielle sur l'entrée dont la tension fait basculer le comparateur.

Selon une seconde variante, les moyens de sélection de la tension de référence immédiatement supérieure à la tension à convertir comprennent des moyens de blocage du circuit de sélection séquentielle sur l'entrée correspondant à la tension immédiatement supérieure à celle qui fait basculer le comparateur.

L'invention a également pour objet un détecteur matriciel de rayonnement électromagnétique comprenant :

■ une matrice de photodétecteurs, chacun des photodétecteurs étant apte à faire varier une grandeur électrique en fonction du rayonnement incident sur celui-ci ;
■ une électronique apte à adresser ladite matrice ligne par ligne, à former des tensions électriques relatives aux éléments photosensibles de la ligne adressée, et à délivrer lesdites tensions sur des sorties parallèles ; et
■ un dispositif de conversion analogique/numérique apte à numériser les tensions électriques délivrées sur les sorties parallèles du circuit de lecture,

Selon l'invention, le dispositif de conversion analogique/numérique est du type précité, un circuit numériseur étant connecté à chaque sortie de l'électronique de lecture.

L'invention a également pour objet un procédé de conversion numérique d'une pluralité de tensions, comportant :

■ une première phase consistant :

o à générer un unique ensemble de tensions de référence constantes dans le temps et codifiées notamment par un numéro d'ordre ou d'adresse ; et

o pour chaque tension à convertir, à comparer celle-ci avec les tensions de référence constantes, et à mémoriser le code identificateur de la tension de référence constante qui lui est immédiatement inférieure, ladite référence constituant les bits de poids fort de la valeur numérique de la tension à convertir,

■ suivie d'une seconde phase consistant :

o à générer un unique ensemble de tensions de référence décroissantes dans le temps et ayant pour valeur initiale les tensions de référence constantes ; et

o pour chaque tension à convertir, à comparer celle-ci avec la tension de référence décroissante ayant pour valeur initiale la tension de référence constante qui lui est immédiatement supérieure, et à compter et mémoriser le nombre d'unités de temps nécessaires à la tension de référence décroissante pour devenir inférieure à la tension à convertir en partant de sa valeur initiale, le nombre d'unité de temps comptées constituant les bits de poids faible de la dite valeur numérique de la tension à convertir.

Selon un mode de réalisation de l'invention, les valeurs des tensions de référence constantes sont discrètes et régulièrement espacées d'un pas prédéterminé, et les tensions de références décroissantes sont décroissantes selon une même rampe prédéterminée. Notamment, les tensions de référence décroissantes décroissent du pas prédéterminé pendant une période de temps égale à $2^L.T_C$, où L est le nombre de bits de poids faible et $T_C$ est la valeur de l'unité de temps.

## BREVE DESCRIPTION DES FIGURES

L'invention sera mieux comprise à la lecture de la description qui suit, donnée uniquement à titre d'exemple, et réalisée en relation avec les dessins annexés, dans lesquels des références identiques désignent des éléments identiques ou analogues, et dans lesquels :

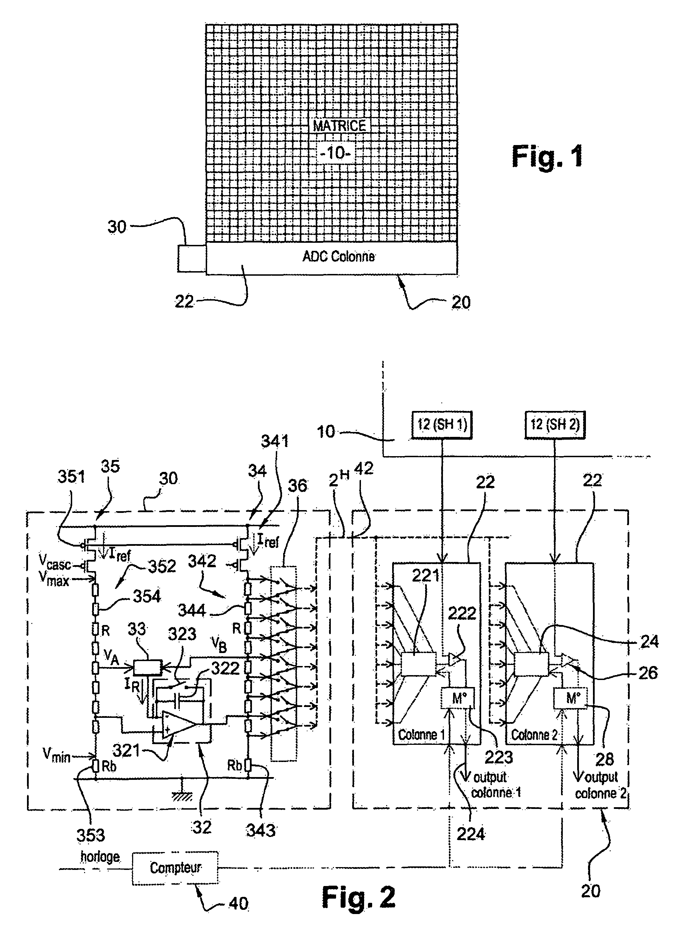

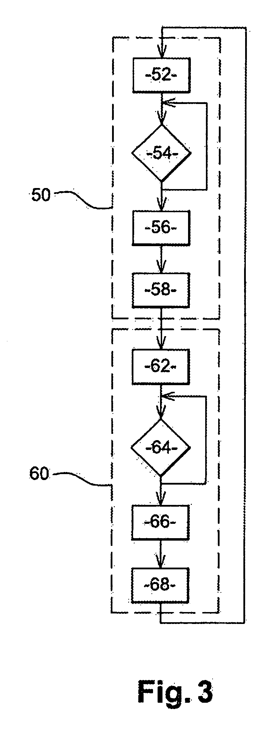

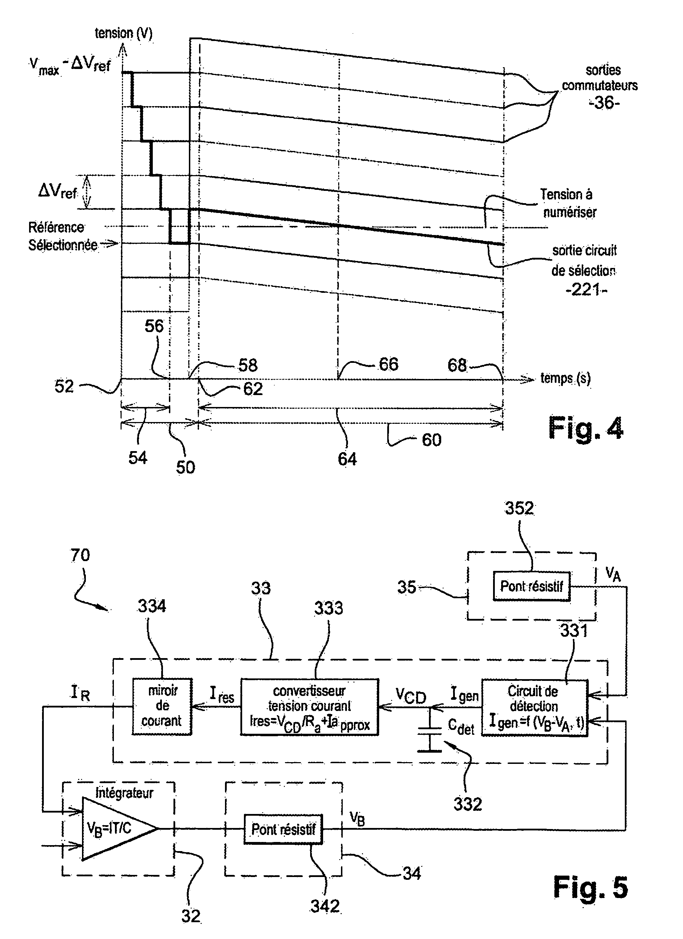

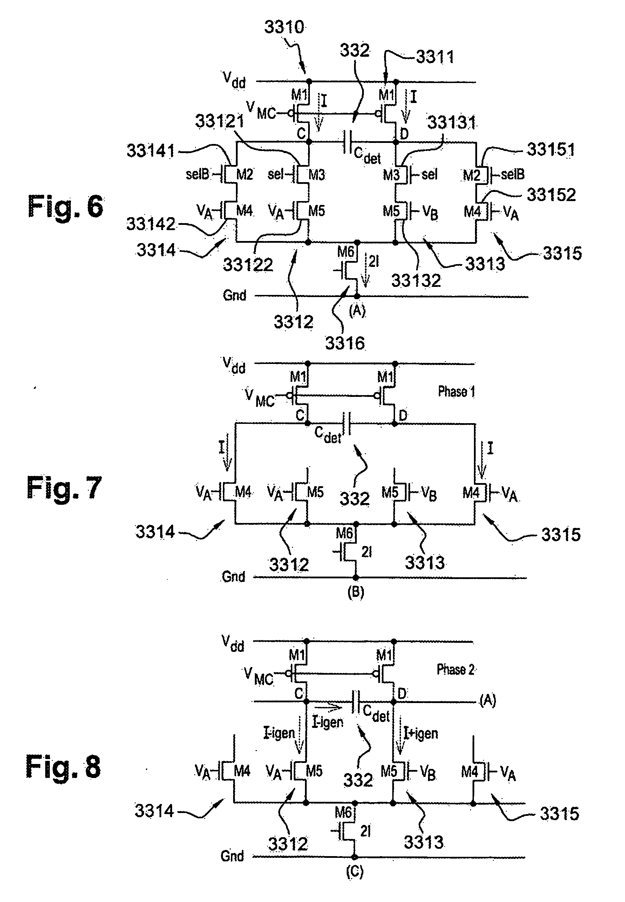

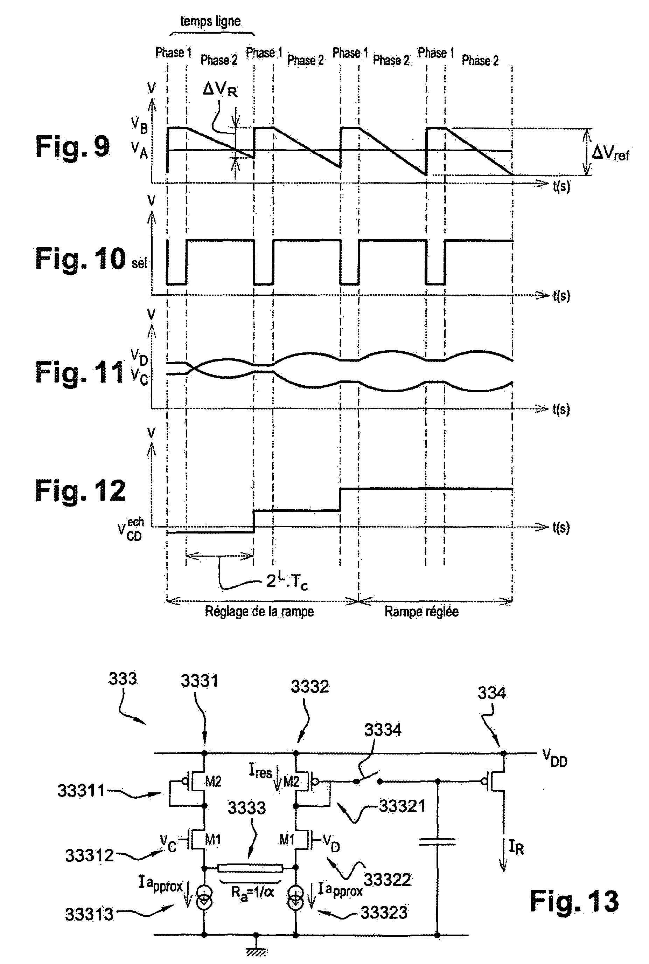

■ les figures 1 et 2 sont des vues schématiques d'un dispositif de conversion analogique/numérique conforme à l'invention et utilisé pour réaliser la numérisation par colonnes des signaux d'un détecteur matriciel ;
■ la figure 3 représente un organigramme des opérations conduites selon la méthode de numérisation objet de l'invention ;
■ la figure 4 illustre un exemple de tracé de la tension délivrée en entrée d'un comparateur d'un circuit numériseur du dispositif de la figure 1 ;
■ la figure 5 est une vue schématique d'une boucle de réglage de la pente de la rampe de tension continue utilisée pour la détermination des bits de poids faible du dispositif de la figure 1 ;
■ la figure 6 est une vue schématique du circuit de réglage d'un courant utilisé pour générer la pente d'une rampe de tension continue et entrant dans la constitution de la boucle de réglage de la figure 4 ;
■ les figures 7 et 8 sont des vues schématiques de ce même circuit dans lesquelles sont illustrés les courants circulant dans ses composants lors de différentes phases du réglage de la pente de la rampe ;
■ les figures 9 à 12 sont des chronogrammes de tensions caractéristiques lors de la phase de réglage de la pente de la rampe ; et
■ la figure 13 est une vue schématique d'un convertisseur de courant entrant dans la constitution de la boucle de la figure 4.

## DESCRIPTION DETAILLEE DE L'INVENTION

On a illustré sur les figures 1 et 2, une matrice d'imagerie **10** d'un détecteur, formée d'une matrice de photodétecteurs et d'une électronique apte à adresser ladite matrice ligne par ligne, à former des tensions électriques relatives aux éléments photosensibles de la ligne adressée, et à délivrer lesdites tensions sur des sorties parallèles au moyen d'échantillonneurs-bloqueurs **12** conservant les tensions le temps nécessaire à leur numérisation. Ce type de détecteur matriciel à mode de lecture dit « balayé » est classique et ne sera donc pas décrit plus en détail par la suite. Par exemple, il s'agit d'un détecteur bolométrique comportant une matrice de microponts bolométriques suspendus au dessus d'un substrat ainsi qu'une circuiterie de lecture, de cadencement et d'adressage séquentiel tel que décrit dans le document « Uncooled amorphous silicon ehancement for $25\mu$m pixel pitch achievement » de E. Mottin et al., Infrared Technology and Application XXVIII, SPIE, vol. 4820. On retiendra seulement que la matrice d'imagerie **10** fournit simultanément un grand nombre de tensions à numériser, à savoir dans l'exemple illustré les tensions issues des photodétecteurs d'une même ligne adressée, et cela ligne après ligne.

Selon l'invention, afin d'effectuer une conversion analogique-numérique des tensions obtenues simultanément pour chaque ligne de la matrice d'imagerie **10** et maintenues dans les échantillonneurs-bloqueurs **12,** un dispositif de conversion analogique/numérique comprend :

■ une ligne **20** de numérisation, formée de circuits **22** de numérisation associés respectivement aux colonnes de la matrice **10** et connectés respectivement aux échantillonneurs-bloqueurs **12** ; et
■ un unique circuit **30** de genèse de tensions de référence, dit « générateur de références », disposé par exemple au bout de la ligne **20** de numérisation, et connecté à chacun des circuits de numérisation **22.**

Les circuits de numérisation **22** et le générateur **30** font préférentiellement partie intégrante de l'électronique de lecture de la matrice d'imagerie **10** (par exemple partie intégrante du circuit de lecture formé dans le substrat d'un détecteur bolométrique à microponts) et sont synchronisés avec la formation des signaux analogiques des échantillonneurs-bloqueurs **12** au moyen d'un séquenceur commun (non représenté). De même, les sorties numériques des circuits **22** de numérisation sont synchronisées en sortie via un multiplexeur série (non représenté) pour délivrer lesdites valeurs à une interface de communication avec la matrice **10,** de manière connue en soi de l'état de la technique.

Le générateur de références **30** comprend :

■ deux circuits formant des ponts **34** et **35** identiques, chacun comprenant une source de courant **341, 351** délivrant un courant constant $I_{ref}$ et un pont résistif **342**, **352**, connecté entre la source de courant **341, 351** et une résistance supplémentaire **343**, **353** de valeur $R_b$ connectée à la masse. Chacun des ponts résistifs **342**, **352** est formé d'une série de $2^H$ résistances **344, 354** sensiblement identiques et de valeur $R$, dans lesquels circule le courant constant $I_{ref}$, et aux noeuds desquels sont définies des tensions $V_{ref}^1$, $V_{ref}^2$, $V_{ref}^3$, ..., $V_{ref}^l$, ..., $V_{ref}^{2^H}$, $V_{ref}^{2^H+1}$. Les sources de courant **341**, **351** sont avantageusement sous la forme de transistors cascodés montés en miroir de courant afin de s'assurer de l'identité des courants circulants dans les deux ponts résistifs **342**, **352** ;
■ un intégrateur **32** comprenant un amplificateur opérationnel **321** contre-réactionné sur son entrée inverseuse « - » par un condensateur **322** de capacité $C$ et par un interrupteur pilotable **323** en parallèle de la capacité **322**. L'entrée non inverseuse « + » et la sortie de l'amplificateur **321** sont en outre respectivement connectées à des noeuds correspondant des ponts résistifs **342**, **352**, autres que les noeuds extrêmes des ponts résistifs **342**, **352**. Dans l'exemple illustré, ces noeuds sont les deuxièmes noeuds des ponts résistifs **342**, **352** en partant de la masse. Le noeud du pont résistif **342** auquel est connecté la sortie de l'amplificateur opérationnel **32**1 sera ci-après désigné sous l'expression « noeud d'injection » ;
■ un circuit générateur de courant **33**, apte à injecter un courant constant $I_R$, dit « courant de rampe », à l'entrée inverseuse « - » de l'amplificateur **321**, comme cela sera expliqué plus en détail par la suite ; et
■ un commutateur pilotable **36**, connecté en entrée aux $2^H+1$ noeuds définis par les $2^H$ résistances **344** du pont résistif **342** et connecté en sortie à un bus parallèle **42** à $2^H$ pistes. Le commutateur **36** sélectionne sur commande soit les $2^H$ tensions des $2^H$ premiers noeuds à partir de la masse, et donc les $2^H$ tensions les plus basses parmi les $2^H+1$ tensions définies sur les noeuds, soit les $2^H$ tensions des $2^H$ derniers noeuds à partir de la masse, et donc les $2^H$ tensions les plus hautes parmi les $2^H+1$ tensions définies sur les noeuds. Les tensions sélectionnées sont ainsi transmises simultanément sur le bus parallèle **42.**

Chacun des circuits de numérisation **22** comprend par ailleurs :

■ un circuit pilotable de sélection séquentielle **221**, connecté au bus **42** pour recevoir les $2^H$ tensions sélectionnées par le commutateur **36**. Le circuit **221** a pour fonction de sélectionner ces tensions les unes après les autres selon leur ordre décroissant. Les tensions reçues étant par construction rangées dans l'ordre, le circuit **221** connecte à cet effet séquentiellement sa sortie à ses entrées ;
■ un comparateur **222,** connecté à la sortie du circuit de sélection **221** et à la sortie de l'échantillonneur-bloqueur **12** correspondant. Le comparateur **222** présente un état bas lorsque le signal en sortie de l'échantillonneur **12** est inférieur à la sortie du circuit de sélection **221,** et un état haut sinon ; et
■ une mémoire numérique **223**, connectée au circuit de sélection **221** et au comparateur **222**. La mémoire **223** est configurée pour mémoriser l'adresse de l'entrée sélectionnée par le circuit de sélection **221** lors du basculement du comparateur **222** dans son état haut, et pour délivrer au circuit de sélection **221** un signal de blocage de celui-ci sur l'entrée dont l'adresse est mémorisée lors de ce basculement. La mémoire **223** est par ailleurs connectée à un bus colonne **224,** par exemple pour sa connexion à un multiplexeur, comme cela est connu en soi.

Enfin, le dispositif de conversion analogique/numérique selon l'invention comporte un compteur de temps **40** recevant un signal d'horloge depuis une horloge (non représentée), par exemple celle déjà prévue pour le cadencement et l'adressage des lignes de la matrice d'imagerie **10.** Le compteur de temps **40** compte le nombre d'unités de temps de valeur prédéterminée $T_C$ écoulées depuis sa réinitialisation et délivre le nombre compté à chacune des mémoires **223** des circuits **22** de numérisation, comme cela sera expliqué plus en détail par la suite.

L'entrée non-inverseuse « + » et la sortie de l'amplificateur **321** étant connectées au même potentiel en raison de l'identité des circuits formant les ponts **34, 35,** l'amplificateur **321** fonctionne donc en suiveur et n'exerce ainsi sensiblement aucune influence sur le pont résistif **342** lorsque l'interrupteur **323** est fermé. Les tensions aux noeuds du pont résistif **342** restent donc constantes.

Les résistances **344** de ce pont étant par ailleurs sensiblement identiques et de valeur $R$, les tensions auxdits noeuds sont donc régulièrement espacées d'un incrément de tension égal à $\Delta V_{ref} = R.I_{ref}$.

Les tensions $V_{ref}^1$, $V_{ref}^2$, $V_{ref}^3,\ldots,V_{ref}^i,\ldots,V_{ref}^{2^H}$, $V_{ref}^{2^H+1}$ ainsi définies aux noeuds du pont résistif **342** sont donc égales à :

$$V_{ref}^1 = V_{\min} = R_b.I_{ref}$$
$$V_{ref}^2 = V_{\min} + \Delta V_{ref}$$
$$V_{ref}^3 = V_{\min} + 2.\Delta V_{ref}$$
$$\ldots$$
$$V_{ref}^i = V_{\min} + (i-1)\Delta V_{ref}$$
$$\ldots$$
$$V_{ref}^{2^H} = V_{\min} + (2^H - 1)\Delta V_{ref}$$
$$V_{ref}^{2^H+1} = V_{\min} + (2^H)\Delta V_{ref} = V_{\max}$$

La dynamique du convertisseur de tension est définie par $V_{ref}^{2^H+1} - V_{ref}^1$, c'est-à-dire une amplitude de tension égale à $2^H.\Delta V_{ref}$.

Lorsque l'interrupteur **323** est ouvert, l'intégrateur **32** intègre le courant $I_R$ du générateur **33** et délivre une tension décroissante sur le noeud d'injection du pont résistif **342** de pente constante égale à $-\dfrac{I_R}{C}$. Le courant $I_{ref}$ étant maintenu identique dans l'ensemble des résistances du pont résistif **342,** les tensions $V_{ref}^1$, $V_{ref}^2$, $V_{ref}^3,\ldots,V_{ref}^i,\ldots,V_{ref}^{2^H}$, $V_{ref}^{2^H+1}$ aux noeuds du pont **342** décroissent donc depuis les valeurs constantes définies ci-dessus avec une pente constante $-\dfrac{I_R}{C}$. Ainsi par exemple, la $i^{ème}$ tension est égale à

$$V_{ref}^i(t) = V_{\min} + (i-1)\Delta V_{ref} - \frac{I_R}{C}t \text{ , où t est le temps écoulé depuis l'ouverture de l'interrupteur 321.}$$

Il va à présent être décrit, en relation avec les figures 3 et 4, le procédé de numérisation des tensions en sortie des échantillonneurs **12** mis en oeuvre par le dispositif de conversion analogique/numérique venant d'être décrit.

La figure 3 est un organigramme dudit procédé. La figure 4 illustre quant à elle l'évolution temporelle des tensions en sortie du commutateur **36,** de la tension en sortie d'un circuit de sélection **221** d'un circuit de numérisation **22** particulier, ainsi qu'une tension à convertir par ce circuit de numérisation **22** particulier.

Le procédé comporte deux phases successives, à savoir une première phase **50** de détermination des bits de poids fort des valeurs numériques des tensions à numériser, suivie d'une seconde phase **60** de détermination des bits de poids faible desdites valeurs numériques.

Selon l'invention, la numérisation est réalisée sur H bits de poids fort et L bits de poids faible.

Le nombre de résistances **344** du pont résistif **352** est choisi égal à une puissance de deux, à savoir $2^H$. Le courant $I_R$ est quant à lui choisi pour que chacune des tensions du pont résistif **342** décroisse de l'incrément de tension $\Delta V_{ref}$ pendant une durée prédéterminée égale à $\Delta T_L = 2^L.T_C$. Il est ainsi obtenu une rampe de tension continue de pente de valeur theorique $\frac{\Delta Vref}{2^L.T_c}$ pour les tensions du pont résistif **342.**

De manière avantageuse, l'entier H est choisi égal à 3 et l'entier L égal à 10, ce qui permet de numériser sur 13 bits de résolution effective les tensions délivrées par une matrice d'imagerie, finesse satisfaisante dans la plupart des cas d'intérêt. Le choix préférentiel de 3 bits de poids fort permet d'une part de limiter le temps de conversion $2^L.T_c$ nécessaire à la seconde rampe, qui représente l'essentiel du temps de conversion total, et de limiter d'autre part le nombre de points critiques que constituent les passages d'un intervalle de poids fort au suivant. En effet, bien que le circuit de conversion proposé soit conçu pour répondre au besoin, une très faible erreur de pente peut produire une erreur sur le dernier bit, il convient donc de limiter la fréquence d'occurrence de ces conversions sensibles, fréquence proportionnelle à $2^H$

La phase **50** de détermination des bits de poids fort débute par la réinitialisation des mémoires **223** des circuits de numérisation **22,** ce qui a pour effet de réinitialiser les circuits de sélection **221,** et la fermeture de l'interrupteur **321** du générateur de références **30.** L'interrupteur **321** étant fermé, l'amplificateur opérationnel fonctionne donc en suiveur de sorte que les tensions aux noeuds du pont résistif **342** sont constantes.

Lors de l'étape d'initialisation **52,** le commutateur **36** est également commandé pour sélectionner les $2^H$ tensions les plus basses des noeuds du pont **342.** Ces tensions constituent alors des tensions de référence constantes, régulièrement espacées du $\Delta V_{ref}$ entre les tensions $V_{min}$ et $V_{max}$, utilisées pour la détermination des H bits de poids forts des valeurs numériques des tensions à convertir.

La phase **50** se poursuit alors, dans chaque circuit de numérisation **22,** par la sélection séquentielle, en **54,** des entrées du circuit de sélection **221** et la délivrance de l'entrée sélectionnée au comparateur **222.** La sélection séquentielle se poursuit tant que l'entrée sélectionnée est supérieure à la tension à convertir reçue par le comparateur **222** de l'échantillonneur-bloqueur **12** correspondant.

Cette sélection séquentielle est illustrée à la figure 4 dans laquelle la tension en sortie du circuit de sélection **221** prend dans un premier temps la forme d'une rampe discrète décroissante en escalier, cette rampe débutant à la tension $V_{max}$ et ayant des marches régulièrement espacées de l'incrément $\Delta V_{ref}$ -

Dès que la tension en sortie du circuit de sélection **221** est inférieure à la tension à convertir, le comparateur **222** bascule, en **56,** sur son état haut. La mémoire **223** stocke alors en mémoire l'adresse, c'est-à-dire la codification, de l'entrée sélectionnée du circuit de sélection **221** et émet à destination de celui-ci un signal de blocage. Le circuit **221** reste alors bloqué sur l'entrée d'adresse mémorisée dans la mémoire **223.** Cette adresse constitue ainsi la valeur des H bits de poids fort, augmentée d'une unité, de la valeur numérique de la tension à convertir.

Une fois les bits de poids fort déterminés (avec excès d'une unité) pour l'ensemble des tensions à convertir stockées dans les échantillonneurs-bloqueurs **12,** le procédé se poursuit alors par la commande, en **58,** du commutateur **36** pour que celui-ci sélectionne les $2^H$ tensions les plus hautes aux noeuds du pont résistif **342.** Comme les résistances du pont résistif **342** sont identiques, cela a ainsi pour effet d'incrémenter les tensions constantes en entrée des circuits de sélection **221** de la valeur $\Delta V_{ref}$, comme cela est illustré à la figure 4.

Ainsi, avant le basculement du commutateur **36,** la tension sélectionnée par un circuit de sélection **221** est la tension de référence immédiatement inférieure à la tension à convertir correspondante et après le basculement du commutateur **36,** la tension sélectionnée par le circuit **221** est la tension de référence immédiatement supérieure.

Ce décalage de l'incrément $\Delta V_{ref}$ permet notamment d'éviter l'effet dit de « trigger de Schmidt » des comparateurs **222.** En effet, comme cela sera expliqué ci-après, la seconde phase **60** du procédé a pour but de déterminer la valeur des L bits de poids faible, à l'aide d'une seconde comparaison mise en oeuvre par les comparateurs **222.** Il est avantageux pour la précision du point de basculement de ceux-ci, que la seconde comparaison soit effectuée en approchant le seuil de basculement du même côté que lors de la première comparaison de la première phase **50.** A la suite de l'incrément des tensions reçues par les circuits de sélection **221,** la tension en sortie de chaque circuit de sélection **221** est de nouveau supérieure à la tension à convertir correspondante. Ainsi, les comparateurs **222** basculent tous dans leur état bas et sont donc à nouveau prêts pour changer d'état avec le même sens de basculement sur un croisement de leurs entrées.

En variante, le commutateur **36** est omis et les $2^H$ tensions aux noeuds des résistances **344** sont fournies directement aux circuits de sélection **221.** Dans cette variante, chaque mémoire **223** comprend une première zone allouée à la mémorisation de l'adresse de l'entrée du circuit de sélection **221** correspondant lors du basculement du comparateur **222** associé, et une seconde zone allouée à la mémorisation de l'adresse sur laquelle le circuit de sélection **221** est bloquée pendant la seconde phase **60.** Lors du basculement du comparateur **222,** l'adresse sélectionnée est alors copiée dans les deux zones de la mémoire **223.** Une fois la première phase **50** terminée, l'adresse stockée dans la première zone de chaque mémoire **223** est décrémentée d'une unité (et forme ainsi les purs H bits de poids fort). Un circuit de sélection **221** sélectionne donc la tension de référence immédiatement supérieure à la tension à convertir correspondante.

Cette variante présente l'avantage d'assurer une continuité temporelle des tensions véhiculées dans le bus **42** entre les phases **50** et **60,** en maintenant l'immunité par rapport à l'effet « trigger de Schmidt » et permet aussi d'éliminer le commutateur **36.**

La seconde phase **60** de détermination des bits de poids faible débute alors après une durée prédéterminée suivant le basculement du commutateur **36,** par l'ouverture, en **62,** de l'interrupteur **323** du générateur de références **30.** Simultanément, le compteur de temps **40** est réinitialisé.

La fermeture de l'interrupteur **323** initie ainsi, dans chaque circuit de numérisation **22,** une étape de décroissance **64** de la tension en sortie du circuit de sélection **221** selon une rampe continue de pente constante de valeur théorique

$$\frac{\Delta Vref}{2^L.T_C},$$ comme illustré à la figure 4.

Dès que cette tension est inférieure à la tension à convertir correspondante, le comparateur **222** bascule alors dans son état haut en **66.** A cet instant, la mémoire **223** mémorise alors la valeur du compteur de temps **40,** cette valeur constituant ainsi la valeur des L bits de poids faible de la valeur numérique de la tension à convertir.

La seconde phase **60** se termine alors une fois la durée $2^L.T_C$ écoulée depuis la fermeture de l'interrupteur **323,** s'assurant ainsi que l'ensemble des bits de poids faible des tensions à convertir a bien été déterminé. Le contenu des mémoires **223** est alors, en **68,** lu et délivré à une interface de communication au moyen d'un multiplexeur série. Les 3 bits de poids fort passent par un soustracteur numérique (non représenté, par exemple disposé après le multiplexeur série, voire en aval du circuit de lecture) afin de les décrémenter tous d'une unité. En effet, le comparateur **222** a inversé sa sortie lors de la formation des bits de poids fort alors que l'adresse de la tension de référence sélectionnée en entrée avait progressé d'une unité excédentaire. On notera que dans la variante proposée où le commutateur **36** est omis, cette soustraction est déjà réalisée entre les phases **50** et **60,** les bits de poids fort sont alors directement contenus dans la première zone des mémoires **223.**

La seconde phase **60** boucle alors sur la première phase **50** pour un nouveau cycle de conversion de nouvelles tensions délivrées par les échantillonneurs-bloqueurs **12.**

Il convient d'apprécier que la numérisation obtenue selon la description proposée, pour laquelle on incrémente le code des références fixes en partant de la plus élevée pendant la première phase, et on incrémente le compteur de temps pendant la seconde phase, s'étage entre *Vmax* et *Vmin* selon un compte numérique croissant, correspondant à une valeur analogique décroissante. Ainsi, la valeur « 00 --- 00 » correspond à la plus haute tension analogique $V_{max}$ en entrée, et la valeur « 11 --- 11 » correspondant à la plus basse tension analogique $V_{min}$ en entrée. Cette complémentation des valeurs n'a cependant pas d'importance dans le domaine, l'utilisateur sachant bien ce qu'il manipule. Un résultat directement conforme à la grandeur en entrée serait obtenu par une sélection croissante lors de la première phase, et des rampes ascendantes lors de la seconde phase, en restant dans l'esprit de l'invention, sans qu'il soit nécessaire de détailler davantage.

Par ailleurs, la codification d'adresse des références par le sélecteur **221** se fera avantageusement selon ce que l'homme de métier appelle un « code Grey » plutôt que par des adresses numériques ordonnées selon une croissance binaire standard. Ce code est caractérisé par la variation d'un seul bit d'adresse lors du passage d'une référence quelconque à une référence adjacente, évitant ainsi l'éventualité de basculement intempestif du comparateur **222** lors du balayage discret de la première phase de numérisation, selon une technique bien connue de l'homme de métier.

En outre, l'identité des ponts **34** et **35** est instaurée pour des besoins de clarté jusqu'à ce point de l'exposé, mais il sera compris aisément qu'il est avantageux de produire uniquement l'identité des tensions apparaissant aux noeuds équivalents desdits ponts. En effet, il est très simple de produire des résistances **354** et *Rb* X fois plus élevées pour former le pont résistif **352** par rapport aux résistances **344** et *Rb'* formant le pont résistif **342,** qui ne délivre pratiquement aucun courant à ses noeuds, de manière à diviser par le même rapport X sa consommation. Les transistors d'alimentation **341** seront dupliqués également X fois en parallèle par rapport à l'architecture du pont **35** de manière à assurer l'identité de comportement des noeuds de potentiel malgré le rapport X de courant entre les deux ponts. La consommation globale du circuit analogique **30** est ainsi minimisée au juste nécessaire.

Une source d'imprécision de la conversion numérique selon l'invention peut provenir de l'ensemble formé du circuit de genèse de tension **33** et de l'intégrateur **32** en charge de la genèse de la rampe de tension.

En effet, même si le circuit générateur de courant **33** délivre un courant strictement égal à $\frac{C.\Delta Vref}{2^L.T_C}$, à un instant donné et dans des conditions opératoires données, c'est-à-dire qui produit la valeur théorique souhaitée $\frac{\Delta Vref}{2^L.T_C}$ la pente de la rampe de tension, il n'est pas assuré d'obtenir une rampe qui provoque une décroissance de l'incrément $\Delta Vref$ pendant la durée $2^L.T_C$ à un autre instant ou lorsque les conditions opératoires changent. Par exemple, la valeur théorique de la pente suppose l'utilisation d'un amplificateur opérationnel **321** parfait, et une valeur C de la capacité **322** exactement calibrée et constante. En effet, outre cette capacité, tous les composants, qu'ils soient analogiques ou numériques, présentent un comportement variable en fonction notamment de leur usure et de leur température, écartant ainsi la pente de la rampe de la valeur théoriquement obtenue à l'aide d'un courant $I_R$ de valeur $\dfrac{C.\Delta Vref}{2^L.T_C}$. De même, un écart apparait par rapport à la valeur de rampe idéale si le courant $I_R$ s'écarte de la valeur théorique $\dfrac{C.\Delta Vref}{2^L.T_C}$, par exemple en raison d'une dérive de fonctionnement d'une source de courant constante utilisée pour générer le courant $I_R$.

De manière avantageuse, le circuit générateur **33** est configuré pour déterminer un courant $I_R$ en fonction de la décroissance réelle d'une tension d'un noeud du pont résistif **342,** c'est-à-dire en fonction de la pente réelle de la rampe de tension.

Il va à présent être décrit, en relation avec les figures 5 à 12, un mode de réalisation préféré du circuit générateur de courant **33**.

Sur la figure 5, il est représenté une boucle **70** de réglage de la pente de la rampe de tension utilisé pour la détermination des bits de poids faible. Cette boucle **70** comprend le circuit **33,** l'intégrateur **32,** ainsi que les ponts résistifs **34** et **35**.

Plus particulièrement, comme cela est visible sur la figure 5, le circuit **33** est connecté à un noeud du pont résistif **342** pour recevoir la tension $V_B$ de celui-ci, ainsi qu'à un circuit de consigne délivrant une tension $VA$ égale à la valeur souhaitée pour la tension $V_B$ à mi-pente lors de sa phase de décroissance, c'est-à-dire la valeur de cette tension à l'instant $\dfrac{2^L.T_C}{2}$ après la fermeture de l'interrupteur **323** du générateur de références **30.**

Le circuit de consigne est avantageusement constitué du second pont résistif **352.** Par exemple, la résistance du pont **352,** correspondant à la résistance du premier pont résistif **342** au noeud de laquelle est prélevée la tension $V_B$, est formée de deux résistances en série de valeur $\dfrac{R}{2}$ et la tension $V_A$ est prélevée au noeud intermédiaire entre ces deux résistances. Ainsi, lorsque les tensions aux noeuds du premier pont résistif **342** sont constantes, c'est-à-dire lorsque l'interrupteur **221** est fermé, la relation $V_B - V_A = \dfrac{\Delta V_{ref}}{2}$ est vérifiée.

En se référant à nouveau à la figure 5, le circuit générateur de courant **33** comporte :

- ■ un circuit dit « de détection » **331,** recevant les tensions $V_A$ et $V_B$ et produisant un courant $I_{gen}$ asservi à la différence de tensions $V_B$ - $V_A$ et de même signe ;
- ■ un condensateur **332,** connecté au circuit de détection **331** et intégrant le courant $I_{gen}$ produit par celui-ci ;
- ■ une source de courant **333** connectée aux bornes du condensateur **332,** et produisant un courant $I_{res}$ égal à la somme d'un premier courant $I_{approx}$ et d'un second courant $I_{corr}$ proportionnel à la tension $V_{CD}$ aux bornes du condensateur **332.** Plus particulièrement, la source de courant **333** comporte un échantillonneur-bloqueur (non représenté) qui échantillonne et mémorise la tension $V_{CD}$ sur commande, et produit un courant $I_{res} = I_{approx} + \alpha.V_{CD}^{ech}$, où $V_{CD}^{ech}$ est la valeur échantillonnée et mémorisée de la tension $V_{CD}$ et $\alpha$ est un coefficient prédéterminé positif ; et
- ■ un miroir de courant recopiant le courant $I_{res}$ en sortie du circuit **33,** la recopie du courant $I_{res}$ constituant le courant $I_R$.

Le courant $I_{approx}$ est un courant approximatif correspondant à un préréglage du courant $I_R$ sur une valeur proche de, ou égale à, $\dfrac{C.\Delta Vref}{2^L.T_C}$ et le courant $I_{corr}$ est un courant de correction du courant $I_{approx}$ pour obtenir la pente souhaitée.

La figure 6 est une vue schématique du circuit de détection **331**. Le circuit de détection consiste avantageusement en un amplificateur différentiel aux noeuds C et D duquel est connecté le condensateur **332,** et comporte :

- ■ deux transistors à effet de champ **3310, 3311** dont les sources sont connectés à une tension $V_{DD}$ et qui sont connectés par leur grilles à un circuit de contre réaction en mode commun (non représenté) délivrant une tension de commande $V_{MC}$. Les transistors **3310** et **3311** délivrent ainsi le même courant $I$ constant ;

■ deux branches internes **3312, 3313** connectées respectivement aux transistors **3310, 3311.** Chacune de ces branches comporte un premier transistor à effet de champ **33121, 33131** formant interrupteur, commandé par un signal de sélection *sel* et connecté par son drain au drain du transistor **3310, 3311,** et un second transistor à effet de champ de contrôle **33122, 33132** connecté par son drain à la source du transistor **33121, 33131** formant interrupteur. Les transistors **33121, 33131** formant interrupteurs, reçoivent sur leur grille un signal de sélection *sel*. Le transistor de contrôle **33122** de l'une des branches internes **3312** reçoit la tension $V_A$ alors que le transistor de contrôle **33132** de l'autre branche **3313** reçoit la tension $V_B$ ;

■ deux branches externes **3314, 3315** connectées respectivement aux transistors **3310, 3311.** Chacune de ces branches comporte un premier transistor à effet de champ **33141, 33151** formant interrupteur, connecté par son drain au drain du transistor **3310, 3311,** et un second transistor à effet de champ de contrôle **33142, 33152** connecté par son drain à la source du transistor **33141, 33151** formant interrupteur. Les transistors **33141, 33151** formant interrupteurs, reçoivent sur leur grille un signal de sélection *selB = sel* qui est le complémentaire du signal de sélection *sel.* Les transistors formant interrupteurs des branches externes sont donc commandés en opposition des transistors formant interrupteurs des branches internes. Les transistors de contrôle **33142, 33152** reçoivent quant à eux sur leur grille la tension $V_A$ ; et

■ un transistor à effet de champ **3316,** dont le drain est connecté entre les sources des transistors de contrôle **33122, 33132, 33142, 33152** et dont la source est connectée à la masse. Le transistor **3316** fonctionne ainsi en source de courant fixe de valeur 2.$I$.

Les transistors de contrôle **33122, 33132** sont polarisés de telle façon à fonctionner en permanence en mode passant, c'est-à-dire avec une tension grille-source $V_{GS}$ sensiblement au dessus de leur tension de seuil $V_t$ afin que les variations de l'entrée différentielle $V_B$-VA soient correctement traduites par un courant différentiel $I_{gen}$, comme il est détaillé plus loin.

Le réglage de la pente de la rampe se compose d'une alternance de premières phases pendant lesquels l'interrupteur **323** est fermé (dite « phases 1 » comme représentées sur la figure 9 qui illustre l'évolution des tensions $V_A$ et $V_B$ au cours du temps), et de secondes phases pendant lesquels l'interrupteur **323** est ouvert pendant la durée $2^L.T_C$ (dites « phase 2 » comme représentées sur la figure 9).

De manière avantageuse, le réglage de la rampe est réalisé pendant la numérisation des tensions. Ainsi, le signal de sélection *sel* est égal au signal de pilotage de l'interrupteur **323** et le signal *selb* est égal au complément de celui-ci. Le chronogramme du signal de sélection *sel* est représenté à la figure 10.

Pendant une première phase, le signal *sel* est réglé à l'état bas et le signal *selB* est donc réglé à l'état haut. Les transistors **33121, 33131** formant interrupteurs des branches internes **3312, 3313** sont alors dans leur état bloqué, et les transistors **33141, 33151** formant interrupteurs des branches externes **3312, 3313** sont dans leur état passant, comme illustré à la figure 7 qui illustre l'état desdits transistors par un circuit ouvert ou par un court circuit. Les transistors de contrôle **33142, 33152** des branches externes recevant sur leur grille la même tension *VA,* elles sont donc équilibrées de sorte que le même courant $I$ les parcourt. En conséquence, aucun courant ne circule en direction du condensateur **332** qui conserve ainsi une tension $V_{CD}$ constante à ses bornes.

Pendant cette même première phase, la tension $V_{CD}$ est échantillonnée et mémorisée dans l'échantillonneur-bloqueur de la source de courant 333 de sorte que le circuit générateur de courant **33** produit un courant

$$I_R = I_{approx} + \alpha.V_{CD}^{ech}$$ constant pendant toute la seconde phase qui suit.

Pendant cette seconde phase, le signal *sel* est réglé à l'état haut et le signal *selB* est donc réglé à l'état bas. Les transistors **33121, 33131** formant interrupteurs des branches internes **3312, 3313** sont alors dans leur état passant, et les transistors **33141, 33151** formant interrupteurs des branches externes **3312, 3313** sont dans leur état bloquant, comme illustré à la figure 8 qui illustre l'état desdits transistors par un circuit ouvert ou par un court circuit.

En outre, pendant cette seconde phase, l'interrupteur **323** est ouvert de sorte que l'intégrateur **32** intègre le courant $\overline{I_R} = I_{approx} + \alpha.\overline{V_{CD}^{ech}}$ et impose une rampe de tension au noeud d'injection du pont résistif **342.** La tension $V_B$ suit donc ladite rampe, comme illustré à la figure 9 par les portions décroissantes de celle-ci.

Par ailleurs, les transistors de contrôle **33122, 33132** des branches internes **3312, 3313** recevant respectivement sur leur grille des tensions *VA* et $V_B$ différentes, ces branches sont donc déséquilibrées. Il circule ainsi dans la branche interne **3312** contrôlée par la tension $V_A$ un courant $I - \dfrac{I_{gen}}{2}$ **,** et dans la branche interne **3313** contrôlée par la tension $V_B$ un courant $I + \dfrac{I_{gen}}{2}$ .

On montre (voir par exemple « P. Gray and R. Meyer : Analysis and design of analog integrated circuits » J. Wiley & Sons, 4th Revised edition (9 avril 2001) §3, P220) que dans les conditions de polarisation adéquates précédemment indiquées, le courant différentiel s'exprime par la relation :

$$\frac{I_{gen}}{2} = k\frac{W}{4L}(V_B - V_A)\sqrt{\frac{8I}{k\dfrac{W}{L}} - (V_B - V_A)^2}$$

où W et L sont les dimensions de la grille des MOS de contrôle **33122, 33132,** et k un facteur de proportionnalité.

Dans la pratique, la paire différentielle fournit un courant $I_{gen}$ linéaire par rapport au signal d'entrée lorsque la relation $\sqrt{2}\,(V_{GS}\text{-}V_t) > (V_B - V_A)max$ est satisfaite, où $(V_{GS}\text{-}V_t)$ est la marge de polarisation en mode passant des MOS de contrôle **33122 et 33132** au-delà de leur tension de *seuil* $V_t$ . En d'autres termes, la paire différentielle est correctement polarisée lorsque la relation $(V_{GS}\text{-}V_t) > \dfrac{\Delta V_{ref}}{2\sqrt{2}}$ est satisfaite.

Cependant, on notera que la linéarité ainsi obtenue n'est pas nécessaire au fonctionnement de la paire différentielle dans le cadre de l'invention. En effet, une non-linéarité a simplement pour effet une variation du gain de charge de la capacité $C_{det}$ en fonction du signal $(V_B - VA)$. Toutefois, même en présence d'une telle variation, le point d'équilibre de la boucle de contre réaction reste inchangé, et par conséquent la valeur d'équilibre finale de la charge dans le condensateur **332.**

Ainsi dans le cadre de l'invention, le terme « asservi » signifie la relation entre $I_{gen}$ et le signal différentiel $(V_B\text{-}V_A)$, cet asservissement pouvant être proportionnel si le circuit de détection **331** fonctionne en régime linéaire.

Il circule donc dans le condensateur **332** un courant $I_{gen}$ de signe égal au signe de la différence de tension $V_B - V_A$. Ce courant $I_{gen}$ est ainsi intégré dans le condensateur **332** pendant toute la durée $2^L.T_C$ que dure la seconde phase.

Notamment lorsque cette différence est positive, la tension $V_{CD}$ aux bornes du condensateur **332** croit. *A contrario*, lorsque la différence $V_B - VA$ est négative, la tension $V_{CD}$ aux bornes du condensateur **332** décroit. Ainsi, à la fin de la seconde phase, si la différence $V_B - V_A$ est positive plus longtemps qu'elle est négative, la tension $V_{CD}$ aura augmenté, et vice versa.

En revanche, si la différence $V_B - VA$ est positive aussi longtemps qu'elle est négative, la tension $V_{CD}$ garde la même valeur à la fin de la seconde phase. Comme la tension $VA$ est choisie égale à la valeur souhaitée pour la tension $V_B$ à mi-pente, cela signifie que la tension $V_B$ a exactement décru de l'incrément $\Delta V_{ref}$ pendant la durée $2^L.T_C$. Par conséquent, le courant $I_R$ est réglé sur la valeur permettant d'obtenir cette décroissance souhaitée.

De manière avantageuse, le coefficient $\alpha$, utilisé par la source de courant **333** pour produire le courant $I_{res} = I_{approx} + \alpha.V_{CD}^{ech}$ **,** est ajusté de manière à obtenir un gain de contre-réaction sur la valeur du courant de rampe $I_R$ fourni par le circuit générateur **33** conforme aux règles de l'art des systèmes de régulation stables et de faible erreur.

De fait plusieurs cycles de premières phases et de secondes phases sont nécessaires pour obtenir le réglage du courant $I_R$, comme cela est illustré aux figures 11 et 12. On notera à cet égard que le condensateur **332** n'est jamais déchargé pour permettre une modification de la tension $V_{CD}$ d'un cycle à l'autre, et ainsi permettre une stabilisation de cette tension et donc un réglage du courant $I_R$.

La figure 11 représente l'évolution temporelle des tensions $V_C$ et $V_D$ aux deux bornes du condensateur **332** et la figure 12, l'évolution temporelle du terme $V_{CD}^{ech}$ .

Comme cela est visible sur la figure 9, la valeur initiale du courant $I_R$ est trop faible et ne permet pas une décroissance suffisante de la tension $V_B$ (la décroissance $\Delta V_R$ de la première seconde phase est inférieure à l'incrément $\Delta V_{ref}$). Au bout de deux cycles complets de première et seconde phases, la tension $V_{CD}$ ne varie plus, comme cela est visible sur la figure 11, de même que le terme $V_{CD}^{ech}$ **,** comme cela est visible sur la figure 12.

Ainsi, quelle que soit l'erreur de pente initiale par rapport à la pente idéale recherchée, un état stationnaire est obtenu en quelques cycles par convergence naturelle du circuit de genèse de tensions **33** vers ladite pente idéale, en raison de la contre-réaction fractionnée de cycle en cycle mise en oeuvre par celui-ci. Ledit état stationnaire correspond à la valeur asymptotique stable de la tension différentielle $V_{CD}$ prélevée aux bornes du condensateur **332.** Cette tension forme ainsi un « signal d'erreur » qui correspond à la valeur particulière imposant au travers de la source de tension **333** la valeur particulière de courant de rampe $I_R$ qui produit l'équilibre des temps de charge et de décharge du condensateur **332,** sur la durée $2^L.T_C$ de la rampe.

Ainsi, la rampe de seconde phase produite à l'équilibre par l'intégrateur **32** par intégration du courant $I_R$ fourni par le circuit **33** produit un parcours de tension $V_B$ depuis $V_A + \Delta V_{ref}/2$ à $V_A - \Delta V_{ref}/2$. Il en va de même pour toutes les autres tensions de référence extraites des noeuds autres que celui de la tension point $V_B$. Autrement dit, l'excursion totale de tension de rampe est égale à $\Delta V_{ref}$, soit un incrément de numérisation de poids fort, sur l'espace de temps alloué à la seconde phase, soit par définition $2^L.T_C$. C'est le résultat recherché pour assurer l'exactitude de la numérisation de poids faible.

Dans la pratique, un temps de convergence de quelques millisecondes est aisément réalisable, parfaitement compatible avec les besoins de la plupart des applications, en particulier en imagerie.

La figure 13 est une vue schématique d'un mode de réalisation préférée de la source de courant **333.**

Dans ce mode de réalisation, la source de courant **333** comporte deux branches **3331** et **3332** comprises entre une tension $V_{DD}$ et la masse. Chacune de ces branches comporte un transistor à effet de champ à canal p **33311, 33321,** dont la source est connectée à la tension $V_{DD}$ et dont la grille est connectée à son drain, un transistor à effet de champ à canal n **33312, 33322,** dont le drain est connecté au drain du transistor **33311, 33321** et une source de courant constante **33313, 33323** connectée entre la source du transistor **33312, 33322** et la masse. Ces sources de courant sont dimensionnées et polarisées de manière à fournir le courant $I_{approx}$.

La source de courant **333** comprend également une résistance **3333** connectée entre les sources des transistors **33312, 33322** et de valeur Ra = $^1/_\alpha$.

La différence de tension $V_{CD}$ est appliquée entre les grilles des transistors **33312, 33322.**

Les grilles des transistors **33321** de la source de courant **333** et du transistor constituant le miroir de courant **334** sont connectées à une armature d'un condensateur de maintien dont l'autre armature est connectée à un potentiel fixe. Lesdites grilles sont connectées entre elles par un interrupteur **3334** commandé par le signal « *sel* » disposé en amont dudit condensateur. Cette disposition constitue un échantillonneur-bloqueur de la tension de commande du miroir, autrement dit du courant $I_{res}$, de manière alternative et équivalente à l'échantillonnage en amont de la tension $V_{CD}$ pour former la tension $V_{CD}^{ech}$ proposé plus haut pour la clarté d'exposé. Selon cette forme de circuit, la tension $V_{CD}$ n'est pas échantillonnée.

Cette source de courant **333,** qui fonctionne donc comme un convertisseur tension/courant, présente l'avantage d'avoir une très forte impédance d'entrée ce qui permet de ne pas dégrader la tension $V_{CD}$ aux bornes du condensateur **332.** De préférence, la valeur Ra de la résistance **3333** est suffisamment élevée devant l'impédance des transistors **33312, 33322** et des sources de courant **33313** et **33323,** sans toutefois produire une valeur trop faible pour le gain de la boucle de contre réaction. Dans la pratique ce compromis ne pose pas de difficulté, et on obtient dans le miroir **334** une copie échantillonnée du courant $I_{res} = I_{approx} + \alpha V_{CD}$.

Sans pour autant sortir de l'esprit de l'invention il est possible de privilégier une caractéristique du convertisseur plutôt qu'une autre, ou plus généralement, de trouver un compromis optimal entre les divers caractères. Par exemple, il est possible d'optimiser le bruit de numérisation par la mise en oeuvre d'une « dégénérescence » (mise en série d'une résistance avec la source de courant **341)** du miroir relié au circuit **34.** Cet avantage s'obtient au détriment de la vitesse du convertisseur, car la dégénérescence limite le courant $I_{ref}$ injectable dans le pont résistif **342.** Il est aussi possible d'ajuster la plage de courant de rampe accessible en adaptant la résistance *Ra*. Cet ajustement est à entreprendre en relation avec la plage de tension $V_C$- $V_D$ accessible, ainsi qu'en regard du gain global de la boucle de contre-réaction, proportionnel à $1/(Ra.C_{det})$.

Il est apparent que le bouclage interne du générateur de références **30** permet d'assurer le raccordement temporel des tensions de référence entre les diverses phases de numérisation, quelles que soient les variations de température du convertisseur, et même les variations technologiques d'un convertisseur à l'autre. Dès que la précision de distribution des résistances selon les circuits **34** et **35** et l'identité des copies du courant de charge $I_{ref}$ sont suffisantes en relation avec les performances visées du convertisseur, la précision de fonctionnement du convertisseur est maintenue automatiquement quelle que soit la température de fonctionnement. De même, il n'est pas besoin de dimensionner avec une grande précision (en dehors de l'identité des résistances nécessaires à la formation des noeuds de référence des ponts résistifs **342** et **352**) les constituants physiques du convertisseur selon l'invention en regard des caractéristiques liées aux dispersions technologiques.

**Revendications**

1. Dispositif de conversion analogique-numérique apte à recevoir des tensions à convertir sur des entrées parallèles dont il est muni, ledit dispositif comprenant :

   ■ un unique circuit de genèse de tensions (30) apte à générer des tensions de référence constantes puis décroissantes dans le temps, selon des valeurs discrètes, ledit circuit de genèse de tension (30) comprenant :

   o une source de courant (341) apte à générer un premier courant constant ;
   o un premier pont résistif (342), formé de résistances en série et connecté à la source de courant constant, les tensions aux noeuds du premier pont résistif formant les tensions de référence ;
   o une source de tension (32, 33, 34) apte à produire une tension décroissante sur un noeud d'injection du premier pont résistif ;
   o un interrupteur (323) de commande de la connexion de la source de tension au noeud d'injection du premier pont résistif,

   ■ et un circuit de numérisation (22) connecté à chaque entrée parallèle du dispositif, ledit circuit étant connecté au circuit de genèse des tensions de référence (30) et comprenant :

   o des moyens (222) de comparaison de la tension à convertir reçue sur l'une des entrées parallèles du dispositif avec les tensions de référence ;
   o des moyens (221) de sélection de la tension de référence dont la valeur, lorsque ladite tension de référence est constante, est immédiatement supérieure à la tension à convertir ;
   o des moyens (40) de comptage d'un nombre d'unités de temps nécessaires pour que la tension de référence sélectionnée devienne inférieure à la tension à convertir lors de la décroissance de ladite tension de référence ; et
   o des moyens (223) de mémorisation d'une part, d'une référence associée à la tension de référence constante qui est immédiatement inférieure ou égale à la tension à convertir, et d'autre part, du nombre d'unités de temps comptées, les bits de poids fort de la valeur numérique de la tension à convertir correspondant à ladite référence, et les bits de poids faible de ladite valeur numérique correspondant au nombre d'unité de temps comptées,

2. Dispositif de conversion analogique-numérique selon la revendication 1, dans lequel le circuit de genèse des tensions de référence (30) est configuré pour délivrer des tensions de référence régulièrement espacées selon un pas prédéterminé, constantes dans le temps ou décroissantes selon une même rampe de tension de pente prédéterminée.

3. Dispositif de conversion analogique-numérique selon la revendication 2, dans lequel le circuit de genèse des tensions de référence (30) est configuré pour délivrer $2^H$ tensions de référence régulièrement espacées d'un pas prédéterminé et pour faire décroitre celles-ci du pas prédéterminé pendant une période de temps égale à $2^L.T_C$, où H est le nombre de bits de poids fort, L est le nombre de bits de poids faible et $T_C$ est la valeur de l'unité de temps.

4. Dispositif de conversion analogique-numérique selon la revendication 1, dans lequel la source de tension décroissante (32, 33, 34) comporte :

   ■ un circuit de tension (34) configuré pour produire une tension sensiblement identique à celle du noeud d'injection du premier pont en l'absence de connexion de la source de tension décroissante sur le noeud de référence du premier pont résistif (342) ;
   ■ un circuit générateur de courant (33) ;
   ■ un amplificateur opérationnel (321) :

   - contre-réactionné sur son entrée inverseuse par un condensateur (322),
   - dont l'entrée inverseuse est connectée au circuit générateur de courant (33),
   - dont l'entrée non-inverseuse est connectée au circuit de tension (35),
   - et dont la sortie est connectée au noeud d'injection du premier pont résistif (342) ;

   et dans lequel un interrupteur pilotable (323) est contre-réactionné sur l'entrée inverseuse de l'amplificateur opérationnel (321).

**5.** Dispositif de conversion analogique-numérique selon les revendications 2 et 4, dans lequel le générateur de courant (33) comporte :

■ un circuit de détection (331) apte à mesurer la différence entre la tension d'un noeud du premier pont résistif (342) et une valeur attendue pour cette tension à mi-pente, et à produire un courant proportionnel à ladite différence ;
■ un condensateur (332) connecté au circuit de détection apte à intégrer le courant délivré par celui-ci; et
■ une source de courant (333) formant le courant délivré par le générateur de courant (33) en fonction de la tension aux bornes du condensateur.

**6.** Dispositif de conversion analogique-numérique selon l'une quelconque des revendications précédentes, dans lequel le circuit de numérisation (22) comporte en outre un circuit de sélection séquentiel (221) connecté au circuit de genèse des tensions de référence (30) de manière à recevoir de celui-ci les tensions de référence sur des entrées parallèles, ledit circuit de sélection (221) étant apte à sélectionner séquentiellement les tensions de référence selon leurs valeurs décroissantes et à délivrer les tensions sélectionnées aux moyens de comparaison (222).

**7.** Dispositif de conversion analogique-numérique selon la revendication 6, dans lequel les moyens de comparaison (222) comprennent un comparateur (222) connecté aux entrées parallèles du dispositif et à la sortie du circuit de sélection séquentielle (221), et dans lequel les moyens de mémorisation (223) comprennent une mémoire pilotée par la sortie du comparateur (222) et mémorisant l'adresse de l'entrée parallèle du circuit de sélection séquentiel en cours de sélection lors du basculement de la sortie du comparateur.

**8.** Dispositif de conversion analogique-numérique selon la revendication 7, dans lequel :

■ le circuit de genèse des tensions de référence (30) est apte à générer une tension supplémentaire supérieure aux tensions de référence, et comporte un commutateur pilotable (36) apte à sélectionner et délivrer au circuit de sélection séquentielle (221), les tensions les plus basses de l'ensemble formé des tensions de référence et de la tension supplémentaire ou les tensions les plus hautes dudit ensemble ;
■ des moyens de commande aptes à faire basculer le commutateur (36) dans son mode de sélection des tensions les plus hautes lors du basculement du comparateur (222) ; et
■ des moyens de blocage (223) du circuit de sélection séquentielle (221) sur l'entrée dont la tension fait basculer le comparateur.

**9.** Dispositif de conversion analogique-numérique selon la revendication 7, comprenant des moyens de blocage du circuit de sélection séquentielle sur l'entrée correspondant à la tension immédiatement supérieure à celle qui fait basculer le comparateur.

**10.** Détecteur matriciel de rayonnement électromagnétique comprenant :

■ une matrice de photodétecteurs, chacun des photodétecteurs étant apte à faire varier une grandeur électrique en fonction du rayonnement incident sur celui-ci ;
■ une électronique apte à adresser ladite matrice ligne par ligne, à former des tensions électriques relatives aux éléments photosensibles de la ligne adressée, et à délivrer lesdites tensions sur des sorties parallèles ; et
■ un dispositif de conversion analogique/numérique apte à numériser les tensions électriques délivrées sur les sorties parallèles.

*caractérisé* **en ce que** le dispositif de conversion analogique/numérique est conforme à l'une quelconque des revendications précédentes, un circuit numériseur étant connecté à chaque sortie de l'électronique de lecture.

**Claims**

**1.** An analog-to-digital conversion device capable of receiving voltages for conversion on parallel inputs with which it is provided, said device including:

■ a single circuit for the generation of voltages (30) capable of generating reference voltages that are constant and then decreasing over time, according to discrete values, said voltage generation circuit (30) including:

o a current source (341) capable of generating a first constant current;
o a first resistive bridge (342), formed of resistances in series and connected to the constant current source, the voltages at the nodes of the first resistive bridge forming the reference voltages;
o a voltage source (32, 33, 34) capable of producing a decreasing voltage on an injection node of the first resistive bridge;
o a contact breaker (323) for controlling the connection of the voltage source to the injection node of the first resistive bridge,

■ and a digitization circuit (22) connected to each parallel input of the device, said circuit being connected to the reference voltage generation circuit (30) and including:

o means (222) for comparing the voltage for conversion received on one of the parallel inputs of the device with the reference voltages;
o means (221) for selecting the reference voltage whereof the value, when said reference voltage is constant, is immediately higher than the voltage for conversion;
o means (40) for counting a number of time units necessary for the reference voltage selected to become lower than the voltage for conversion when said reference voltage is decreased; and
o means (223) for storing on the one hand, a reference associated with the constant reference voltage which is immediately lower than or equal to the voltage for conversion, and on the other hand, the number of counted time units, the high-order bits of the digital value of the voltage for conversion corresponding to said reference, and the low-order bits of said digital value corresponding to the number of counted time units.

2. The analog-to-digital conversion device as claimed in claim 1, wherein the reference voltage generation circuit (30) is configured to deliver reference voltages evenly spaced apart according to a predetermined pitch, constant over time or decreasing along a single voltage ramp of predetermined slope.

3. The analog-to-digital conversion device as claimed in claim 2, wherein the reference voltage generation circuit (30) is configured to deliver $2^H$ reference voltages evenly spaced apart by a predetermined pitch and to make these decrease by the predetermined pitch over a period of time equal to $2^L.T_C$, where H is the number of high-order bits, L is the number of low-order bits and $T_C$ is the value of the time unit.

4. The analog-to-digital conversion device as claimed in claim 1, wherein the decreasing voltage source (32, 33, 34) comprises:

■ a voltage circuit (34) configured to produce a voltage substantially identical to that of the injection node of the first bridge in the absence of connection between the decreasing voltage source and the reference node of the first resistive bridge (342);
■ a current generator circuit (33);
■ an operational amplifier (321):

- mounted in inverse feedback on its inverting input via a capacitor (322),
- whereof the inverting input is connected to the current generator circuit (33),
- whereof the non-inverting input is connected to the voltage circuit (35),
- and whereof the output is connected to the injection node of the first resistive bridge (342);

and wherein a controllable contact breaker (323) is mounted in inverse feedback on the inverting input of the operational amplifier (321).

5. The analog-to-digital conversion device as claimed in claims 2 and 4, wherein the current generator (33) comprises:

■ a detection circuit (331) capable of measuring the difference between the voltage of a node of the first resistive bridge (342) and an expected value for this voltage at mid-slope, and of producing a current proportionate to said difference;
■ a capacitor (332) connected to the detection circuit and capable of integrating the current delivered thereby; and
■ a current source (333) forming the current delivered by the current generator (33) as a function of the voltage at the terminals of the capacitor.

6. The analog-to-digital conversion device as claimed in any one of the previous claims, wherein the digitization circuit (22) further comprises a sequential selection circuit (221) connected to the reference voltage generation circuit (30) so as to receive the reference voltages therefrom on parallel inputs, said selection circuit (221) being capable of selecting the reference voltages sequentially according to their decreasing values and of delivering the voltages selected to the comparison means (222).

7. The analog-to-digital conversion device as claimed in claim 6, wherein the comparison means (222) include a comparator (222) connected to the parallel inputs of the device and to the output of the sequential selection circuit (221), and wherein the storage means (223) include a memory controlled by the output of the comparator (222) and storing the address of the parallel input of the sequential selection circuit in process of selection when the comparator output flips.

8. The analog-to-digital conversion device as claimed in claim 7, wherein:

   ■ the reference voltage generation circuit (30) is capable of generating an additional voltage higher than the reference voltages, and comprises a controllable switch (36) capable of selecting, and delivering to the sequential selection circuit (221), the lowest voltages of the set formed by the reference voltages and the additional voltage or the highest voltages of said set;
   ■ control means capable of flipping the switch (36) into its mode for the selection of the highest voltages when the comparator (222) flips; and
   ■ means for blocking (223) the sequential selection circuit (221) on the input whereof the voltage flips the comparator.

9. The analog-to-digital conversion device as claimed in claim 7, including means for blocking the sequential selection circuit on the input corresponding to the voltage immediately higher than the one that flips the comparator.

10. An electromagnetic radiation matrix detector including:

    ■ a matrix of photo-detectors, each of the photo-detectors being capable of varying an electric variable as a function of the radiation incident thereon;
    ■ electronics capable of addressing said matrix line by line, of forming electric voltages relative to the photosensitive elements of the addressed line, and of delivering said voltages to parallel outputs; and
    ■ an analog-to-digital conversion device capable of digitizing the electric voltages delivered to the parallel outputs,

    wherein the analog-to-digital conversion device is in accordance with any one of the previous claims, a digitizer circuit being connected to each output of the read electronics.

### Patentansprüche

1. A/D-Wandlervorrichtung, die dazu in der Lage ist, umzuwandelnde Spannungen an parallelen Eingängen, mit denen sie ausgestattet ist, aufzunehmen, wobei die Vorrichtung umfasst:

   ☐ einen einzigen Spannungserzeugungsschaltkreis (30), der dazu in der Lage ist, konstante, dann mit der Zeit abnehmende Referenzspannungen entsprechend diskreten Werten zu erzeugen, wobei der Spannungserzeugungsschaltkreis (30) umfasst:

      o eine Stromquelle (341), die dazu in der Lage ist, einen ersten konstanten Strom zu erzeugen;
      o eine erste Widerstandsbrücke (342), die aus Reihenwiderständen gebildet und an die Konstantstromquelle angeschlossen ist, wobei die Spannungen an den Knoten der ersten Widerstandsbrücke die Referenzspannungen bilden;
      o eine Spannungsquelle (32, 33, 34), die dazu in der Lage ist, eine abnehmende Spannung an einem Zuführungsnoten der ersten Widerstandsbrücke zu erzeugen;
      o einen Unterbrecher (323) zum Steuern der Verbindung der Spannungsquelle mit dem Zuführungsknoten der ersten Widerstandsbrücke,

   ☐ und eine Digitalisierungsschaltung (22), die an jeden parallelen Eingang der Vorrichtung angeschlossen ist, wobei die Schaltung an den Erzeugungsschaltkreis(30) für die Referenzspannungen angeschlossen ist und umfasst:

o Einrichtungen (222) zum Vergleichen der an einem der parallelen Eingänge der Vorrichtung aufgenommenen, umzuwandelnden Spannung mit den Referenzspannungen;

o Einrichtungen (221) zum Auswählen der Referenzspannung, deren Wert, wenn die Referenzspannung konstant ist, unmittelbar höher als die umzuwandelnde Spannung ist;

o Einrichtungen (40) zum Zählen einer Anzahl von Zeiteinheiten, die notwendig sind, damit die ausgewählte Referenzspannung bei der Abnahme der Referenzspannung niedriger als die umzuwandelnde Spannung wird; und

o Einrichtungen (223) zum Speichern einerseits einer Referenz, die mit der konstanten Referenzspannung zusammenhängt, die unmittelbar niedriger als die umzuwandelnde oder gleich der umzuwandelnden Spannung ist, und andererseits der Anzahl von gezählten Zeiteinheiten, wobei die werthohen Bits des digitalen Werts der umzuwandelnden Spannung der Referenz entsprechen und die wertniedrigen Bits des digitalen Werts der gezählten Anzahl von Zeiteinheiten entsprechen.

2. A/D-Wandlervorrichtung nach Anspruch 1, bei der der Erzeugungsschaltkreis (30) für die Referenzspannungen dazu ausgelegt ist, entsprechend einem vorbestimmten Schritt gleichmäßig beabstandete Referenzspannungen bereitzustellen, die zeitlich konstant oder entsprechend einer Spannungsflanke mit vorbestimmter Steigung abnehmend sind.

3. A/D-Wandlervorrichtung nach Anspruch 2, bei der der Erzeugungsschaltkreis (30) für die Referenzspannungen dazu ausgelegt ist, um einen vorbestimmten Schritt regelmäßig beabstandete $2^H$ Spannungen bereitzustellen und diese während eines Zeitraums gleich $2^L.T_C$ um den vorbestimmten Schritt abnehmen zu lassen, wobei H die Anzahl werthoher Bits ist, L die Anzahl wertniedriger Bits ist, und TC der Wert der Zeiteinheit ist.

4. A/D-Wandlervorrichtung nach Anspruch 1, bei der die Quelle (32, 33, 34) abnehmender Spannung umfasst:

☐ einen Spannungskreis (34), der dazu ausgelegt ist, eine Spannung zu erzeugen, die im Wesentlichen gleich derjenigen des Zuführungsknotens der ersten Brücke bei Nichtvorhandensein einer Verbindung der Quelle abnehmender Spannung am Referenzknoten der ersten Widerstandsbrücke (342) ist;

☐ einen Stromgeneratorschaltkreis (33);

☐ einen Operationsverstärker (321):

- der an seinem umschaltenden Eingang durch einen Kondensator (322) gegengekoppelt ist,
- dessen umschaltender Eingang an den Stromgeneratorschaltkreis (33) angeschlossen ist,
- dessen nicht umschaltender Eingang an den Spannungskreis (35) angeschlossen ist,
- und dessen Ausgang an den Zuführungsknoten der ersten Widerstandsbrücke (342) angeschlossen ist;

und bei der ein steuerbarer Unterbrecher (323) am umschaltenden Eingang des Operationsverstärkers (321) gegengekoppelt ist.

5. A/D-Wandlervorrichtung nach den Ansprüchen 2 und 4, bei der der Stromgenerator (33) umfasst:

☐ eine Erfassungsschaltung (331), die dazu ausgelegt ist, den Unterschied zwischen der Spannung eines Knotens der ersten Widerstandsbrücke (342) und eines für diese Spannung bei halber Steigung erwarteten Werts zu messen und einen zu diesem Unterschied proportionalen Strom zu erzeugen;

☐ einen Kondensator (332), der an die Erfassungsschaltung angeschlossen und dazu in der Lage ist, den von dieser bereitgestellten Strom zu integrieren; und

☐ eine Stromquelle (333), die den vom Stromgenerator (33) bereitgestellten Strom in Abhängigkeit von der Spannung an den Klemmen des Kondensators formt.

6. A/D-Wandlervorrichtung nach einem der vorhergehenden Ansprüche, bei der die Digitalisierungsschaltung (22) darüber hinaus eine sequentielle Wahlschaltung (221) umfasst, die an den Erzeugungsschaltkreis (30) für die Referenzspannungen angeschlossen ist, um von diesem die Referenzspannungen an parallelen Eingängen aufzunehmen, wobei die Wahlschaltung (221) dazu in der Lage ist, sequentiell die Referenzspannungen entsprechend ihren abnehmenden Werten auszuwählen und die ausgewählten Spannungen den Vergleichseinrichtungen (222) bereitzustellen.

**7.** A/D-Wandlervorrichtung nach Anspruch 6, bei der die Vergleichseinrichtungen (222) einen Komparator (222) umfassen, der an parallele Eingänge der Vorrichtung und an den Ausgang der sequentiellen Wahlschaltung (221) angeschlossen ist, und bei der die Speichereinrichtungen (223) einen Speicher umfassen, der durch den Ausgang des Komparators (222) gesteuert ist und die Adresse des parallelen Eingangs der sequentiellen Wahlschaltung während der Auswahl beim Umschalten des Ausgangs des Komparators speichert.

**8.** A/D-Wandlervorrichtung nach Anspruch 7, bei der:

☐ der Erzeugungsschaltkreis (30) für die Referenzspannungen dazu in der Lage ist, eine zusätzliche Spannung zu erzeugen, die höher ist als die Referenzspannungen, und einen steuerbaren Umschalter (36) umfasst, der in der Lage ist, die Spannungen auszuwählen und der sequentiellen Wahlschaltung (221) bereitzustellen, die von der Gesamtheit am niedrigsten sind, die durch die Referenzspannungen und die zusätzliche Spannung gebildet sind, oder die Spannungen, die von der Gesamtheit am höchsten sind;
☐ Steuereinrichtungen, die dazu in der Lage sind, den Umschalter (36) in seiner Auswahlbetriebsart für höchste Spannungen beim Umschalten des Komparators (222) umschalten zu lassen; und
☐ Einrichtungen (223) zum Sperren der sequentiellen Wahlschaltung (221) an dem Eingang, dessen Spannung den Komparator umschalten lässt.

**9.** A/D-Wandlervorrichtung nach Anspruch 7, Einrichtungen zum Sperren der sequentiellen Wahlschaltung an dem Eingang umfassend, der der Spannung entspricht, die unmittelbar höher ist als diejenige, die den Komparator umschalten lässt.

**10.** Matrixdetektor für elektromagnetische Strahlung, Folgendes umfassend:

☐ eine Matrix aus Fotodetektoren, wobei jeder der Fotodetektoren dazu in der Lage ist, eine elektrische Größe in Abhängigkeit von der auf ihn einfallenden Strahlung variieren zu lassen;
☐ eine Elektronik, die dazu in der Lage ist, die Matrix Zeile für Zeile anzusprechen, elektrische Spannungen zu bilden, die in Relation zu den lichtempfindlichen Elementen der angesprochenen Zeile stehen, und diese Spannungen an parallelen Ausgängen bereitzustellen; und
☐ eine A/D-Wandlervorrichtung, die dazu in der Lage ist, die an den parallelen Ausgängen bereitgestellten elektrischen Spannungen zu digitalisieren,

**dadurch gekennzeichnet, dass** die A/D-Wandlervorrichtung einem der vorhergehenden Ansprüche entspricht, wobei eine Digitalisierungsschaltung an jeden Ausgang der Leseelektronik angeschlossen ist.

**Fig. 1**

**Fig. 2**

Fig. 3

tension (V)

$V_{max} - \Delta V_{ref}$

sorties
commutateurs
-36-

$\Delta V_{ref}$

Tension à
numériser

Référence
Sélectionnée →

sortie circuit
de sélection
-221-

56

52

58

62

66

68

temps (s)

54

50

64

60

**Fig. 4**

70

352

334

33

333

35 —

Pont résistif

$V_A$

331

$I_R$

miroir
de
courant

$I_{res}$

convertisseur
tension courant
Ires=$V_{CD}/R_a$+Iapprox

$V_{CD}$

$I_{gen}$

$C_{det}$

Circuit de
détection
$I_{gen}$=f $(V_B-V_A, t)$

332

intégrateur

$V_B=IT/C$

Pont résistif

$V_B$

32

342

34

**Fig. 5**

23

Fig. 6

Fig. 7

Fig. 8

**Fig. 9**

temps ligne

Phase 1  Phase 2  Phase 1  Phase 2  Phase 1  Phase 2  Phase 1  Phase 2

$V$

$V_B$

$\Delta V_R$

$V_A$

$\Delta V_{ref}$

$t(s)$

**Fig. 10**  sel

$V$

$t(s)$

**Fig. 11**  $V_D$ / $V_C$

$V$

$t(s)$

**Fig. 12**

$V$

$V_{CD}^{ech}$

$t(s)$

$2^L . T_c$

Réglage de la rampe     Rampe réglée

333     3331     3332     3334     334

$V_{DD}$

33311     $I_{res}$ M2     M2

M2     3333     33321

$V_C$     M1     M1     $V_D$

33312

$I_{approx}$     $R_a = 1/\alpha$     $I_{approx}$     33323

33313     $I_R$     33322

**Fig. 13**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Martijn F. SNOEIJ et al.** Multiple-ramp column-parallele ADC architectures for CMOS image sensors. *IEEE JOURNAL OF SOLID-STATE CIRCUITS,* 01 Décembre 2007, vol. 42 (12
- **Seunghyun LIM et al.** A high-speed CMOS image sensor with column-parallel two-step single-slope ADCs. *IEEE TRANSACTIONS ON ELECTRON DEVICES,* 01 Mars 2009, vol. 56 (3

- **E. Mottin et al.** Uncooled amorphous silicon ehancement for $25\mu$m pixel pitch achievement. *Infrared Technology and Application XXVIII,* vol. 4820
- **P. Gray ; R. Meyer.** Analysis and design of analog integrated circuits. J. Wiley & Sons, 09 Avril 2001, 220